# EUROPEAN PATENT APPLICATION

(11) **EP 0 930 378 A1**
(43) Date of publication of application: **21.07.1999**
(21) Application number: 99200073.7
(22) Date of filing: 13.01.1999
(51) Int. Cl.: C23C 16/56, C23C 16/26, H01L 23/00

(54) **Method of processing of CVD diamond coatings**

(30) Priority: 20.01.1998 US 71923 P
(71) Applicant: Saint-Gobain Industrial Ceramics, Inc., Worcester, MA 01615-0138 (US)
(72) Inventor: Fabis, Philip M., Medfield, MA 02052 (US)
(74) Representative: Richebourg, Michel François

(57) **Abstract**

A thin film diamond coating and substrate composite is treated in a low temperature plasma processing system with an oxidizing gaseous element. During the treatment, the oxidative plasma reacts with graphitic surface carbon, resulting in volatile surface molecules which are `pumped off' the diamond; and oxygen in the plasma bonds to diamond carbon to terminate the diamond thin film coating surface. The process results in a thin film diamond coating having increased resistivity (to at least approximately 10¹⁰ohm-cm). An integrated circuit (IC) package (100) is also provided in which the chip (112) is mounted on a thermally conductive, yet electrically resistive base (104) comprised of a substrate coated with a diamond thin film coating treated according to the above described process of the invention. Leads (106) are provided in thermal contact with the base, but, due to the electrical resistivity of the base, are electrically insulated from the chip. Wires (116) between pads on the leads and the chip provide the electrical connection. The leads (116) provide a direct conduit for thermal dissipation. The IC package permits increased heat dissipation from the entire package in a manner which does not interfere with its electrical properties and is less expensive to manufacture.

## Description

### BACKGROUND OF THE INVENTION

### 1. Field of the Invention

This invention relates broadly to a thin film diamond coatings provided on substrates. More particularly, this invention relates to thin film diamond coatings on substrates having high electrical resistivity and methods for forming the same. The invention has particular application to integrated circuit packages, although it is not limited thereto.

### 2. State of the Art

The ever-increasing demand for smaller, high performance information systems has lead to the adoption of the integrated circuit (IC) as the information processing center of the modern computer. These integrated circuits, or chips, are typically housed within standard ceramic, plastic or metal packages and carry information between the chip and other information processing units within the system.

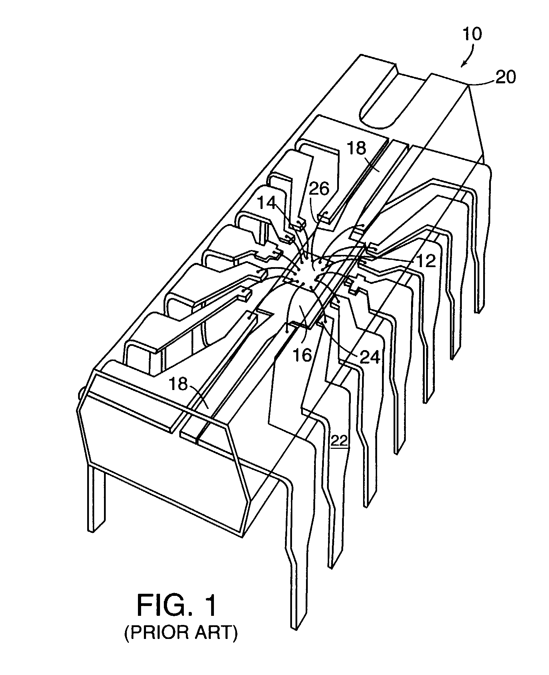

In one type of plastic encapsulated dual in-line package, such as the package 10 shown in prior art Figure 1, an integrated circuit chip 12 having a plurality of bonding pads 14 at its perimeter is fastened to a die substrate 16 which is held by two tie bars 18 embedded in a thermoplastic molding compound 20, such as a polyamide.

A plurality of metal legs, or leads 22, are also embedded in the thermoplastic compound 20 with (typically) nickel plated bonding pads 24 at their inner ends. The leads 22 and substrate 16 are parts which have been separated from a lead frame in the course of assembly of the package 10. Wires 26 are bonded to the bonding pads 14 of the chip 12 and the bonding pads 24 of the leads 22 to connect the chip 12 to the leads 22. The leads 22 provide connection means to other circuit components.

Because electrical inefficiencies in the chip generate heat, the temperatures of both the chip 12 and other parts of the package supporting the chip significantly rise during use. It is known that such elevated temperatures can degrade the system's performance. For example, because many of the system's critical processes rely on kinetic phenomena which become accelerated by increased temperature, failures in metallization and the bonded interface occur during extended use. Accordingly, heat production by the chip, often termed "thermal density", has become a significant design consideration which threatens to limit the further miniaturization of information systems within reasonable costs constraints.

Conventional treatment of the thermal density problem has met with limited success. For example, in the prior art design shown in Figure 1, heat generated by the chip 12 is dissipated through the tie bars 18, the thermoplastic molding 20, and the wires 26 connecting the chip 12 and the leads 22 of the lead frame. However, each of these thermal conduits is only marginally effective. In particular, the wires 26 are poor thermal conduits because they have a small cross section (e.g, about 0.002 inches in diameter). The tie bars 18, while having a larger cross section (e.g., about 0.010 inches thick) are ineffective thermal conduits because they are truncated at each end of the IC package. There are no metal thermal paths to the outside after the IC package molding process. Moreover, the thermoplastic molding has an extremely low thermal conductivity.

One present improvement in thermal dissipation connects a more thermally conductive, high surface area material (known as a 'heat spreader') to the chip. Although heat spreaders succeed in dissipating hot spots on the chip, they do not significantly assist in removing heat from the package as a whole. Another present improvement involves blowing air across either the chip or attached heat spreader, thereby removing heat convectively from the package. Although this improvement succeeds in removing more heat from the package, it adds cost, takes up room, requires geometry changes in the area around the package, and subjects the chip to failure due to mechanical failure of the blower.

Referring to Figure 2, co-owned European Patent Application No. 95201765.5 discloses an improved IC package 30 in which the chip 32 is mounted on a thermally conductive, yet electrically resistive base 33. The leads 42 are in thermal contact with the base 33, but, due to the electrical resistivity of the base, are electrically insulated from the chip 32. Wires 46 between the pads 44 on the leads 42 and the pads 48 on the chip 32 provide the electrical connection. The leads in direct contact with the base 33 provide a conduit for thermal dissipation. Because the leads 42 have thicknesses of about 0.010 inches (compared to about 0.002 inches for the wires), they possess a much greater cross-section than the wires 46. For leads and wires made of materials having the same thermal conductance, the leads are more thermally conductive than the wires and the plastic encapsulant. Ideally, the improved IC package permits increased heat dissipation from the entire package in a manner which does not interfere with its electrical properties.

The preferred base in the improved IC package design is a free standing diamond film which is both an excellent thermal conductor (at least 10 W/cm K) and excellent electrical insulator (at least 10¹⁰ ohm-cm). The diamond film is chemically vapor deposited (CVD) in a thickness of between approximately 150 and about 200 microns. However, because the free standing diamond film is unsupported and brittle, it is difficult to handle and subject to cracking during manufacture of the IC package. Moreover, in order to deposit diamond to a thickness on the order of 150 to 200 microns, an expensive and time consuming process is required.

Because of the expense of a free standing diamond film, it would be more desirable to utilize even thinner films (on the order of 30 microns and under) in a manner more readily manipulated. Such thinner films can be produced more quickly, and as a result, more inexpensively. One manner of creating a thinner diamond film which can be handled is to provide the film as a coating on a relatively thick metallic or non-metallic substrate; i.e., the diamond film is never removed from the substrate, so that the diamond/substrate composite is handled together. However, thin film diamond coatings do not exhibit the same electrical resistivity as thicker films; i.e., the resistivity of thin diamond film coatings is typically under 10¹⁰ ohm-cm. The chemical nature of CVD thin film diamond coatings, primarily the inclusion of non-diamond impurities, such as sp² graphitic carbon, at the near surface, surface, and grain boundaries interferes with the high resistivity (at least 10¹⁰ ohm-cm) of the diamond that is desired for the electrical isolation of the leads and the successful performance of an IC package having a base incorporating such diamond thin film coatings on a substrate. As such, thin diamond film coatings have not been used as a thermally conductive, electrically resistive component in IC packages.

With thicker diamond films, in contrast to diamond thin film coatings, it has been found that annealing affects the surface chemistry to improve the electrical resistance. Yet, annealing is not an option with diamond thin films coated on an appropriate substrate; the high temperature required for annealing (typically approximately 900°C and above) may degrade the thin film diamond coating, the substrate, and particularly the interface adhesion of the diamond thin film coating to the substrate.

### SUMMARY OF THE INVENTION

It is therefore an object of the invention to provide a reliable method for increasing the resistivity of thin film CVD diamond coatings.

It is another object of the invention to particularly increase the resistivity of diamond coatings on metallic and non-metallic substrates.

It is also an object of the invention to increase diamond thin film coating resistivity without degrading the coating, the substrate on which the coating resides, or the adhesion of the diamond to the substrate.

In accord with these objects, which will be discussed in detail below, a thin film diamond coating and substrate composite is treated in a plasma processing system, e.g., a glow discharge/barrel etcher, with an oxidizing gaseous element, e.g., oxygen and its plasma created derivatives. Other chemically halogen-like elements having a strong electron affinity for the sp² bonding structure of graphitic carbon (relative to their affinity for the sp³ bonding structure of diamond carbon) and other potential terminal species on the diamond thin film coating near surface and surface can also be used. The plasma processing system oxygen-etches the diamond thin film coating surface and near surface in a non-destructive, relatively low pressure, low temperature environment.

During the treatment the oxidative plasma chemically and physically reacts with the graphitic carbon, resulting in volatile surface molecules which are `pumped off' the diamond as carbon-oxygen species. Reactive oxygen species in the plasma bond to diamond carbon to terminate the diamond thin film coating surface. The process results in a thin film diamond coating having increased resistivity (to at least approximately 10¹⁰ ohm-cm). There are no observable detrimental effects to the diamond thin film coating, the substrate, or the diamond/substrate interface. In addition, it has also been found that the above treatment can improve the dielectric constant and the loss tangent.

Therefore, and also according to the invention, an integrated circuit (IC) package is also provided in which the chip is mounted on a thermally conductive, yet electrically resistive base comprised of a substrate coated with a diamond thin film coating treated according to the above described process of the invention. Leads are provided in thermal contact with the diamond thin film coating of the base, but due to the electrical resistivity of the diamond thin film coating of the base are electrically insulated from the chip. Wires between the leads and the chip provide the electrical connection for the IC package. The leads provide a direct conduit for thermal dissipation. The IC package permits increased heat dissipation from the entire package in a manner that does not interfere with its electrical properties and that is less expensive to manufacture. Moreover, the base, including a relatively thick substrate portion, is easier to handle after diamond deposition and during IC package manufacture.

Additional objects and advantages of the invention will become apparent to those skilled in the art upon reference to the detailed description taken in conjunction with the provided figures.

### BRIEF DESCRIPTION OF THE DRAWINGS

Figure 1 is a prior art integrated circuit package;

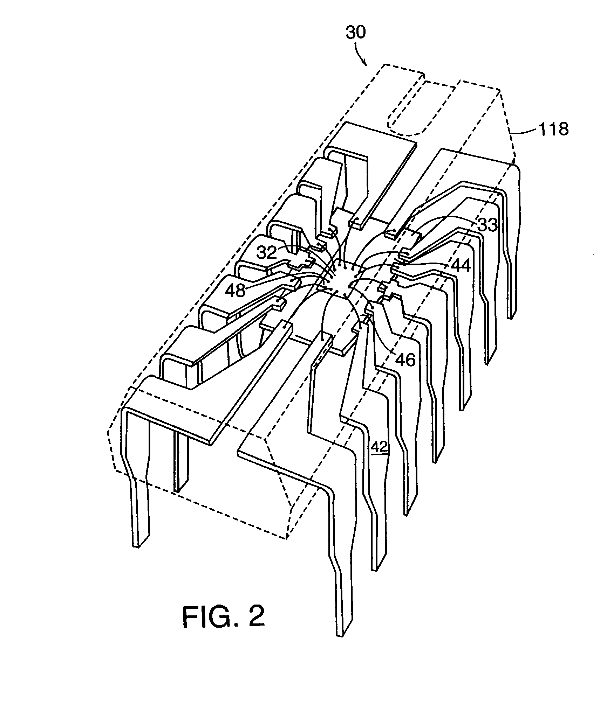

Figure 2 is a co-owned heat dissipating integrated circuit package; and
Figure 3 is the integrated circuit package design of the present invention.

### DETAILED DESCRIPTION OF THE PREFERRED EMBODIMENTS

According to the preferred embodiment of the invention, a thin film diamond coating is deposited onto either of a metallic or non-metallic substrate via a known chemical vapor deposition (CVD) method. A preferred metallic substrate is molybdenum (Mo), while a preferred non-metallic substrate is silicon carbide (SiC). Preferably the diamond film coating is deposited to a thickness of under a 100 microns, and more preferably to a thickness of under 35 microns.

The diamond thin film coating and substrate are next treated in a plasma processing system to etch the surface and near surface of the coating with an oxidizing agent to chemically terminate the surface. According to a preferred embodiment of the invention, the plasma processing system is a 13.56 MHz glow discharge/barrel etcher operated under low pressure, e.g., 50-100 mTorr. A gaseous element, preferably oxygen, is fed into the glow discharge/barrel etcher, and is energized to form an etchant, i.e., oxygen and its plasma-created derivatives. The gaseous element has a relatively strong affinity for the sp² bonding structure of graphitic carbon and other potential terminal species on the diamond thin film coating surface; i.e., the oxidant has an affinity to share or extract electrons from the terminal species on the diamond surface. Preferably the gaseous element is at least 99.999 percent oxygen. The electron temperature of the plasma etchant is characteristic of a glow discharge device, approximately 1000-10000 K. However, the temperature of the coating/substrate remains under approximately 200°C, rising in temperature from the kinetic impact of the etchant.

The diamond thin film coating and substrate composite is plasma etched for preferably 5 to 30 minutes. During the processing, the etchant predominantly reacts with the sp² graphitic carbon, and preferably any other terminal species on the diamond coating surface, to create volatile molecules, e.g., carbon-oxygen species, which when further struck by the highly energized plasma etchant are `pumped off' the diamond coating surface. Moreover, the etchant stably bonds to sp³ diamond carbon with minimal reaction to chemically terminate the diamond thin film coating surface and near surface.

The process results in a thin film diamond coating having increased resistivity (to at least approximately 10¹⁰ ohm-cm). There are no observable detrimental effects to the diamond thin film coating, the substrate or the diamond/substrate interface. In addition, it has also been found that the above treatment can improve the dielectric constant and the loss tangent.

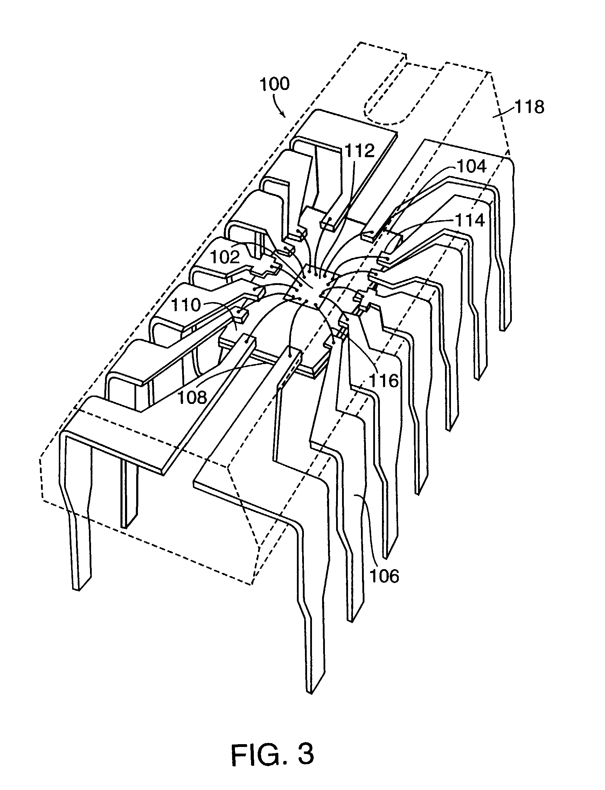

Turning now to Figure 3, and also according to the invention, an integrated circuit (IC) package 100 utilizing the diamond thin film coating, described above, is also provided. The package generally includes an integrated circuit chip 102 bonded to a base 104 and a plurality of leads 106, or legs, also bonded to the base. According to the invention, the base 104 comprises a substrate 108 and a diamond thin film coating 110 provided to the substrate. The diamond thin film coating 110 is generally under 100 microns thick, and is typically under 35 microns thick. The diamond thin film coating and substrate composite has been treated with an oxidizing agent, as described above, to increase the electrical resistivity of the diamond thin film coating preferably to at least 10¹⁰ ohm-cm. The leads 106 are thermally coupled to the diamond thin film coating 110, as is the chip 102. The chip 102 includes a plurality of chip bonding pads 112. Likewise, a bonding pad 114, typically nickel plated, is provided to each lead 106. Wires 116 extend from pads 114 on the leads 106 to pads 112 on the chip 102 to electrically couple the leads 106 to the chip 102. A thermoplastic molding compound 118, such as a polyamide, encapsulates the chip 102 and the base 104 and partially encapsulates the leads 106. Heat generated at the chip 102 is conducted through the diamond thin film coating 110 to the leads 106. The leads provide a direct conduit for thermal dissipation.

The IC package permits increased heat dissipation from the entire package in a manner which does not interfere with its electrical properties and is less expensive to manufacture. Moreover, the base, including a relatively thick substrate portion, is easier to handle after diamond deposition and during IC package manufacture.

There have been described and illustrated herein a method of processing the surface and near surface of a diamond thin film coating and an integrated circuit package utilizing the processed thin film diamond coating. While particular embodiments of the invention have been described, it is not intended that the invention be limited thereto, as it is intended that the invention be as broad in scope as the art will allow and that the specification be read likewise. Thus, while a 13.56 MHz glow discharge/barrel etcher plasma processing system has been disclosed for etching the diamond thin film coating surface and near surface, it will be appreciated that other glow discharge systems, as well as arc jet and microwave plasma systems may be used as well. Furthermore while oxygen has been disclosed as the gaseous element, it will be appreciated that other chemically halogen-like elements having a relatively strong affinity for the sp² bonding structure of graphitic carbon and other potential terminal species on the diamond thin film coating surface can also be used. For example, fluorine and chlorine may also be used. Moreover, while certain metallic and non-metallic substrate materials have been disclosed, it will be appreciated that other materials compatible with electronic packaging may also be used. Also, while it is preferable to process the diamond for approximately 5 to 30 minutes, it will be recognized that processing of a longer or shorter duration may be performed. Moreover, while it is preferable to process the diamond thin film coating and substrate such that the coating and substrate do not rise above approximately 200°C, it will be appreciated that the diamond/substrate composite may be processed at higher temperatures as long as the processing temperature does not subject the coating, substrate, and coating/substrate interface to any deleterious effects. Furthermore, while one application of the processed thin film diamond coating/substrate composite has been disclosed with respect for use in an IC package, it will be appreciated that the processed thin film coating/substrate composite has other uses. It will therefore be appreciated by those skilled in the art that yet other modifications could be made to the provided invention without deviating from its spirit and scope as so claimed.

## Claims

1. A method of processing a composite of a substrate and a thin film diamond coating provided on said substrate, said thin film diamond coating having at least one of a near surface and a surface including graphitic carbon, comprising:
a) providing said composite into a plasma processing system;
b) providing an oxidizing etchant into the plasma processing system;
c) plasma etching said thin film diamond coating with the oxidizing etchant to cause said thin film diamond coating to be chemically terminated,
wherein said chemical termination increases the resistivity of said thin film diamond coating.

2. A method according to claim 1, wherein:
said plasma processing system is one of a glow discharge barrel etcher, an arc jet system, and a microwave plasma system.

3. A method according to claim 1, wherein:
said resistivity of said thin film coating is at least approximately 10¹⁰ ohm-cm.

4. A method according to claim 1, wherein:
said oxidizing etchant is formed from a chemically halogen-like element in gaseous form.

5. A method according to claim 1, wherein:
said oxidizing etchant has a relatively strong affinity for the sp² bonding structure of graphitic carbon relative to the affinity for the sp³ bonding structure of diamond.

6. A method according to claim 4, wherein:
said oxidizing etchant is oxygen and its plasma created derivatives.

7. A method according to claim 1, wherein:
said plasma etching does not cause said composite to exceed approximately 200°C.

8. A method according to claim 1, wherein:
said plasma etching occurs for approximately 5 to 30 minutes.

9. A composite, comprising:
a) a substrate; and
b) a thin film diamond coating deposited on said substrate, said thin film diamond coating having a surface which is chemically terminated.

10. A composite according to claim 9, wherein:
said diamond thin film coating has an electrical resistivity of at least approximately 10¹⁰ ohm-cm.

11. A composite according to claim 10, wherein:
said thin film diamond coating has a thickness of under 100 microns.

12. A composite according to claim 11, wherein:
said thin film diamond coating has a thickness of under 35 microns.

13. A composite according to claim 9, wherein:
said composite is metallic.

14. A composite according to claim 13, wherein:
said composite is molybdenum.

15. A composite according to claim 10, wherein:
said composite is non-metallic.

16. A composite according to claim 15, wherein:
said composite is silicon carbide.

17. An integrated circuit package, comprising:
a) an integrated circuit;
b) a plurality of electrically and thermally conductive legs in both electrical and thermal connection with said integrated circuit; and
c) a base having a non-diamond substrate and a thin film diamond coating adhered to said substrate, said diamond film of said base being in intimate thermal contact with both said integrated circuit and said plurality of legs.

18. An integrated circuit package according to claim 17, further comprising:
d) an encapsulant encapsulating said integrated circuit and said base and partially encapsulating said plurality of legs.

19. An integrated circuit package according to claim 17, wherein:
said diamond thin film coating has an electrical resistivity of at least 10¹⁰ ohm-cm.

20. An integrate circuit package according to claim 17, wherein:
said diamond thin film coating has a chemically terminated surface.

21. An integrated circuit package according to claim 17, wherein:
said thin film diamond coating has a thickness of less than approximately 100 microns.

22. An integrated circuit package according to claim 21, wherein:
said thin film diamond coating has a thickness of less than approximately 35 microns.

23. An integrated circuit package according to claim 17, wherein:
said substrate is metallic.

24. An integrated circuit package according to claim 23, wherein:
said substrate is molybdenum.

25. An integrated circuit package according to claim 19, wherein:
said substrate is non-metallic.

26. An integrated circuit package according to claim 25, wherein:
said substrate is silicon carbide.
